Europäisches Patentamt

European Patent Office

Office européen des brevets

(11) Veröffentlichungsnummer : **0 050 239**
**B1**

(12) **EUROPÄISCHE PATENTSCHRIFT**

(45) Veröffentlichungstag der Patentschrift :
11.04.84

(21) Anmeldenummer : 81107720.5

(22) Anmeldetag : 29.09.81

(51) Int. Cl.³ : **H 03 J 7/18, H 04 B 1/16**

(54) Verfahren zum Modulationsvergleich von zwei Rundfunksignalen und Schaltanordnung zur Durchführung des Verfahrens.

(30) Priorität : 03.10.80 DE 3037411

(43) Veröffentlichungstag der Anmeldung :
28.04.82 Patentblatt 82/17

(45) Bekanntmachung des Hinweises auf die Patenterteilung : 11.04.84 Patentblatt 84/15

(84) Benannte Vertragsstaaten :
DE FR GB IT SE

(56) Entgegenhaltungen :
DE-A- 2 840 533
DE-C- 1 591 144
US-A- 3 585 598
US-A- 3 810 156
US-A- 3 919 479

(73) Patentinhaber : BAYERISCHE MOTOREN WERKE
Aktiengesellschaft
Postfach 40 02 40 Petuelring 130
D-8000 München 40 (DE)

(72) Erfinder : Steins, Wilfried
Solalindenstrasse 27
D-8000 München 82 (DE)
Erfinder : Tigges, Michael
Lautbertstrasse 3
D-8050 Freising (DE)
Erfinder : Weishaupt, Walter
Melingstrasse 12
D-8000 München 71 (DE)

(74) Vertreter : Bullwein, Fritz Bayerische Motoren Werke
Aktiengesellschaft
Postfach 40 02 40 - AJ-23 Petuelring 130
D-8000 München 40 (DE)

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Verfahren zum Modulationsvergleich von zwei Rundfunksignalen und Schaltanordnung zur Durchführung des Verfahrens

Die Erfindung bezieht sich auf ein Verfahren zum Modulationsvergleich von zwei Rundfunksignalen, bei denen HF-Träger-Signalen unterschiedlicher Frequenz ein Modulationssignal überlagert ist.

Ein derartiger Modulationsvergleich dient beispielsweise in Rundfunkempfängern von Kraftfahrzeugen dazu, neben dem empfangenen Sender einen weiteren Sender mit gleichem Programm bereitzuhalten, auf den bei Schwächerwerden des empfangenen Senders selbsttätig umgeschaltet werden kann. Damit ist trotz der gerade bei diesem Anwendungsfall häufig stark wechselnden Empfangsbedingungen ein störungsfreier Rundfunkempfang gewährleistet.

Ein Verfahren der eingangs genannten Art ist aus der DE-PS 15 91 144 im Prinzip bekannt. In dieser Druckschrift findet sich jedoch keinerlei Hinweis darauf, in welcher Weise ein derartiger Modulationsvergleich durchgeführt werden kann.

Der Erfindung liegt die Aufgabe zugrunde, ein Verfahren der eingangs genannten Art zu schaffen, das sich durch geringen Aufwand auszeichnet und das einen Modulationsvergleich auch von Sendern ermöglicht, die unterschiedliche Standorte besitzen.

Die Erfindung löst diese Aufgabe dadurch, daß von den beiden Modulationssignalen ein zeitgleicher Ausschnitt digitalisiert und in je einen Speicher eingelesen wird, daß die Speicherinhalte für den Modulationsvergleich korreliert werden und daß bei nicht gegebener Übereinstimmung die Speicherinhalte gegeneinander verschoben und erneut miteinander korreliert werden, wobei die Verschiebung und die Korrelation der beiden Speicherinhalte bei fehlender Übereinstimmung solange fortgesetzt wird, bis die gesamte relative Verschiebung der Speicherinhalte der Zeitdauer eines Speicherinhaltes entspricht.

Die beiden Modulationssignale der beiden HF-Träger-Signale werden somit nicht fortlaufend, sondern lediglich in Form eines kurzzeitigen Ausschnitts miteinander korreliert. Durch die relative Verschiebung der beiden Speicherinhalte können Laufzeitunterschiede, die durch unterschiedliche Entfernungen des Empfängers von den Sendern bedingt sind, ausgeglichen werden. Durch die Digitalisierung der beiden Modulationssignale ist ferner ein exakter Vergleich auch bei unterschiedlichem Pegel möglich. Da nicht ohne weiteres feststellbar ist, welches der beiden, möglicherweise inhaltsgleichen Modulationssignale möglicherweise vorauseilt, läßt sich eine sichere Aussage über die Gleichheit der beiden Modulationssignale nur dann treffen, wenn die Korrelation der beiden Speicherinhalte bei fehlender Übereinstimmung so lange fortgesetzt wird, bis die gesamte relative Verschiebung der Speicherinhalte der Zeitdauer eines Speicherinhaltes entspricht. Würde beispielsweise stets nur derselbe Speicherinhalt gegenüber dem anderen Speicherinhalt zeitlich verzögert vollständig mit dem anderen Speicherinhalt korreliert, so wirkt der Speicher als Umlaufspeicher. Ein Teil des nicht verzögerten Speicherinhalts ist somit gegenüber einem Teilinhalt dieses Umlaufspeichers verzögert.

Aus der US-A-3 919 479 ist es bekannt, einen Sender mit Hilfe eines früher ausgesandten Referenzsignals zu identifizieren. Dabei werden das Referenzsignal und zeitlich gleichlange Abschnitte des zu identifizierenden Senders miteinander verglichen. Da das Referenzsignal einem Modulationssignal des gewünschten Senders gleich ist, ist der gewünschte Sender gefunden, wenn tatsächlich das Referenzsignal und einer der Abschnitte des Modulationssignales des untersuchten Senders gleich sind. Dabei ist jedoch nicht vorgesehen, die Untersuchung des Senders anhand von zwei zeitgleich am Ort des Empfängers eintreffenden Signalen vorzunehmen. Vielmehr wird das Referenzsignal bevor des Sender das Modulationssignal ausstrahlt, gespeichert. Auch erfolgt die Untersuchung nicht in der Weise, daß ein Abschnitt des untersuchten Senders zeitlich gegenüber dem Referenzsignal verschoben wird und diese Verschiebung bei fehlender Übereinstimmung der beiden Signale solange fortgesetzt wird, bis die gesamte relative Verschiebung der beiden Signale der Zeitdauer eines der Signale entspricht. Vielmehr werden stets « neue » Abschnitte des untersuchten Senders benutzt und lediglich einmalig in Beziehung zum Referenzsignal gesetzt.

Die Zeit, in der eine ggf. fehlende Übereinstimmung der Programme zweier Sender festgestellt werden kann, ist gleich der Anzahl der möglichen relativen Verschiebungen der beiden Speicherinhalte multipliziert mit der Auslesezeit. Hinzukommt die Einlesezeit für die beiden Speicherinhalte, die durch die verwendeten Bauteile festgelegt ist. Eine fehlende Übereinstimmung der beiden Programme läßt sich dadurch besonders schnell feststellen, wenn das Auslesen der digitalisierten Modulationssignale aus den Speichern mit wesentlich größerer Geschwindigkeit als das Einlesen erfolgt.

Der Vergleich der beiden Speicherinhalte kann in verschiedener Weise erfolgen. So ist es beispielsweise möglich, bei in Form von Dualzahlen vorliegenden Speicherinhalten die Differenz der entsprechenden Zahlen zu bilden und zu summieren. Ebenso ist es möglich, das Faltprodukt der beiden Speicherinhalte zu bilden. Eine schaltungsmäßig besonders einfache Realisierung besteht darin, daß die als Binärwerte gegebenen Speicherinhalte Wert für Wert miteinander verglichen, die Zahl ungleicher Wertepaare gezählt und bei Überschreiten eines vorgegebenen Maximalwerts dieser zahl ein Verschiebesignal für einen Speicher ausgelöst wird. Die Digitalisierung der Modulationssignale in binärer Form bietet darüber hinaus den Vorteil, daß Pegelunterschiede der beiden Modulationssignale einen relativ unbedeutenden Einfluß auf das Ergebnis der Korrelation besitzen.

Bei Rundfunksendern, auch mit verschiedenem Programm, liegt häufig zu bestimmten Zeiten, insbesondere unmittelbar vor der vollen Stunde, kein Modulationssignal vor. Würde in dieser Zeit ein Modulationsvergleich vorgenommen, so könnte dieser irrtümlich die Gleichheit der beiden Programme zur Folge haben. Um eine derartige fehlerhafte Aussage zu vermeiden, werden in einem weiteren erfinderischen Schritt Modulationspausen innerhalb der Modulationssignale ab einer vorgegebenen Länge nicht mehr eingelesen. In den Speichern verbleibt dann der vorherige Inhalt mit der Folge, daß die Ungleichheit der beiden Programme festgetellt wird.

Eine besonders einfache schaltungstechnische Realisierung des Verfahrens wird dadurch ermöglicht, daß die Speicher als Schreib/Lese-Speicher ausgebildet und ihre Adresseingänge mit den Ausgängen je eines Adressen-Zählers verbunden sind, der an einem Taktgeber angeschlossen ist.

Der beschriebene Vergleich der als Binärzahlen vorliegenden Speicherinhalte wird dann besonders vereinfacht, wenn die Ausgänge der beiden Speicher über ein EXCLUSIV-ODER-Gatter mit dem Eingang eines Fehler-Zählers verbunden ist. Bleibt die Fehlerrate unter einem vorgegebenen Wert, kann mit Sicherheit auf gleiches Programm der beiden Sender geschlossen werden.

Andererseits kann das Überschreiten der zulässigen Fehlerrate, d. h. des Maximalwerts ungleicher Wertepaare an einem diesem Maximalwert zugeordneten Ausgang des Fehlerzählers festgestellt werden. Ist dieser Ausgang mit einem bistabilen Kippglied verbunden, das über ein monostabiles Kippglied eine Torschaltung zwischen dem Taktgeber und dem Eingang eines der beiden Adressen-Zähler kurzzeitig undurchlässig steuert, so kann die Verschiebung des diesem Adressen-Zählers zugeordneten Schreib/Lese-Speicher auf besonders einfache Weise erreicht werden. Die Einschaltzeit des monostabilen Kippglieds entspricht dabei der relativen Verschiebung der beiden Speicherinhalte.

Schließlich läßt sich die Information, ob die Programme der beiden Sender gleich sind, in besonders einfacher Weise dadurch gewinnen, daß ein weiterer Ausgang der monostabilen Kippstufe mit einem nachtriggerbaren Zeitschalter verbunden ist, dessen Einschaltdauer etwas größer als ein Auslösezyklus der Speicher ist. Die monostabile Kippstufe liefert, sofern die beiden Programme ungleich sind, nach jedem Auslösezyklus einen Impuls. Unterbleibt dieser Impuls nach Ablauf des Auslösezyklus, so bedeutet dies, daß die beiden Programme gleich sind. In diesem Fall liefert der nachtriggerbare Zeitschalter ein Signal.

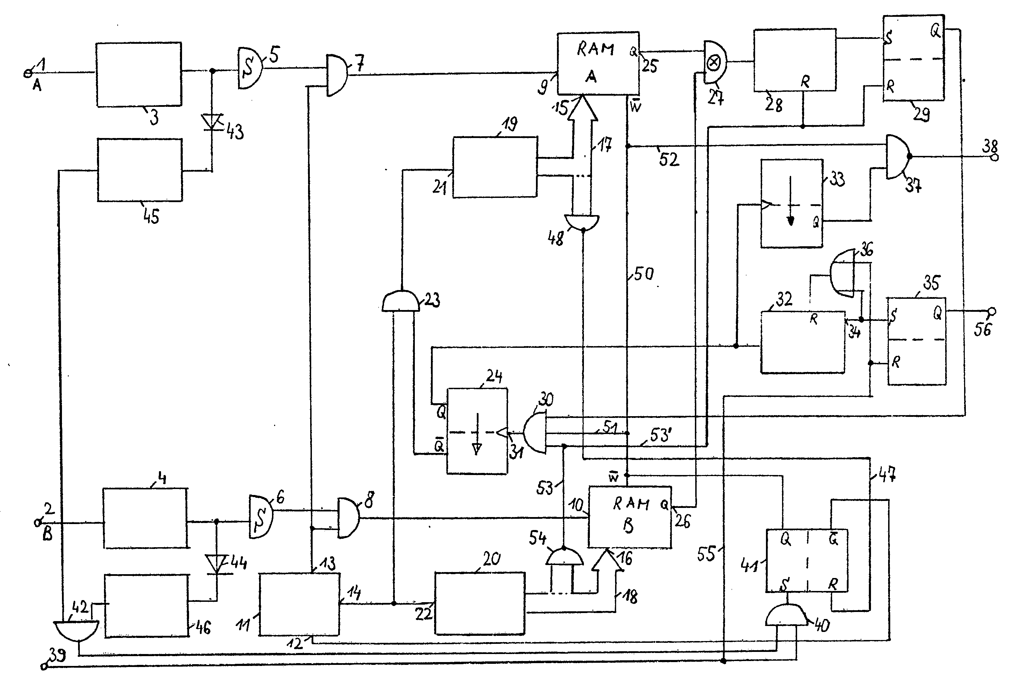

Die Erfindung ist anhand der Zeichnung näher erläutert. In dieser ist eine Schaltanordnung dargestellt, mit der der Modulationsvergleich für Rundfunksignale unterschiedlicher Trägerfrequenz durchgeführt werden kann.

Die analogen Modulationssignale A und B zweier Sender A' und B' mit unterschiedlich frequenten HF-Trägerfrequenzen stehen an Eingängen 1 und 2 an. Die Eingänge 1 und 2 sind parallel über NF-Verstärker 3 und 4, Schmitt-Trigger 5 und 6 und UND-Gattern 7 und 8 an Leseeingänge 9 und 10 zweier Schreib/Lese-Speicher RAM A und RAM B angeschlossen. Die Gatter 7 und 8 sind mit einem Taktgeber 11 verbunden, der unterschiedliche Frequenzen von z. B. 15,6 und 62,4 kHz sowie 1 MHz liefert. Der Taktgeber 11 ist hierzu beispielsweise — nicht dargestellt — als Zähler ausgebildet, der die Schwingungen eines hochfrequenten Schwingkreises mißt und an desen Ausgänge 13 und 14 die erforderlichen Taktfrequenzen vorliegen.

Die im einzelnen nicht dargestellten Adress-Eingänge 15 und 16 der Speicher RAM A und RAM B sind über der Einfachheit halber als Pfeile 17 und 18 dargestellte parallele Leitungen mit den Ausgängen von Adressen-Zählern 19 und 20 verbunden, deren Eingänge 21 und 22 am Ausgang 14 des Taktgebers 11 angeschlossen sind. Während der Zähler 20 unmittelbar am Taktgeber 11 angeschlossen ist, wird für den Zähler 19 ein UND-Gatter 23 zwischengeschaltet, dessen zweiter Eingang am Ausgang $\overline{Q}$ eines monostabilen Kippglieds 24 angeschlossen ist.

Die Lese-Ausgänge 25 und 26 der beiden Speicher RAM A und RAM B sind an einem EXCLUSIV-ODER-Gatter 27 angeschlossen, das mit einem Fehler-Zähler 28 verbunden ist. Dieser ist an einem bistabilen Kippglied 29 angeschlossen, dessen Ausgang über ein UND-Gatter 30 auf den Eingang des monostabilen Kippglieds 24 geführt ist. Ein weiterer Ausgang Q dieses Kippglieds 24 ist mit dem Eingang eines Zyklenzählers 32 und einem nachtriggerbaren Zeitschalter 33 verbunden. Der Ausgang 34 des Zählers 32 ist am Eingang S eines bistabilen Kippglieds 35 und über ein ODER-Gatter 36 am eigenen Eingang R angeschlossen. Ein Ausgang Q des Kippglieds 35 ist an einem Ausgang 56 der Schaltanordnung, ein Ausgang Q des nachtriggerbaren Zeitschalters 33 über ein NAND-Gatter 37 an einem Ausgang 38 angeschlossen.

Ein weiterer Eingang 39 der Schaltanordnung ist an den Eingängen R des bistabilen Kippglieds 35 und des Zyklen-Zählers 32 — für diesen unter Zwischenschaltung des ODER-Gatters 36 — und über ein UND-Gatter 40 am Eingang S eines als Schreib/Lese-Umschalter dienenden bistabilen Kippglieds 41 angeschlossen. Dessen Ausgang Q ist auf Schreib/Lese-Befehls-Eingänge $\overline{W}$ der Speicher RAM A und RAM B geschaltet.

Ebenfalls am Eingang S des Kippglieds 41 über das UND-Gatter 40 angeschlossen ist ein UND-Gatter 42, an dessen Eingänge die über Dioden 43 und 44 gleichgerichteten und über Schwellwertschalter 45 und 46 geführten Ausgangssignale der Verstärker 3 und 4. anliegen. Ein weiterer Eingang R des Kippglieds 41 ist über eine Leitung 47 und ein NAND-Gatter 48 an sämtlichen Ausgängen des Adress-Zählers 19 angeschlossen. Schießlich führt ein Ausgang $\overline{Q}$ des Kippglieds 41 zum Eingang 12 des Taktgebers und bewirkt in bekannter Weise die Umschaltung der Taktfrequenz.

An der zu den Eingängen $\overline{W}$ der Speicher RAM A und RAM B führenden Leitung 50 sind über Leitungen 51 und 52 die UND-Gatter 30 und 37 angeschlossen. Das UND-Gatter 30 ist ferner über eine Leitung 53 und ein NAND-Gatter 54 an sämtlichen Ausgängen des Adress-Zählers 20 angeschlossen.

Liegt am Eingang 39, beispielsweise am Ende eines Sendersuchlaufs, ein als Einspeicherbefehl dienendes Signal vor, so kippt das bistabile Kippglied 41 um und gibt den Einspeicherbefehl an die Schreib-/Lese-Speicher RAM A und RAM B weiter. In diese Speicher gelangt dann ein digitalisierter, zeitgleicher Ausschnitt der an den Eingängen 1 und 2 anstehenden Modulationssignale der beiden Sender A' und B'. Der Sender A' ist dabei der empfangene Sender oder aber ein bereits mit Hilfe der dargestellten Schaltanordnung gefundener Sender gleichen Programms, während der Sender B' daraufhin geprüft werden soll, ob er ebenfalls dasselbe Programm besitzt. Die Digitalisierung der durch die Verstärker 3 und 4 verstärkten Modulationssignale erfolgt mit Hilfe der Schmitt-Trigger 5 bzw. 6 und der UND-Gatter 7 bzw. 8. Die Schmitt-Trigger 5 und 6 erzeugen jeweils eine Folge von Impulsen, deren Breite in etwa gleich der Breite der positiven Anteile der Modulationssignale ist. Diese Impulse werden durch die UND-Gatter mit einer vom Taktgeber 11 am Ausgang 13 gelieferten Frequenz von z. B. 15,6 kHz getaktet. Die mit einer Speicherkapazität von z. B. $4.096 \times 1$ bit versehenen Speicher RAM A und RAM B enthalten somit an ihren, durch den mit einer Taktfrequenz des Taktgebers 11 am Ausgang 14 von z. B. 62,5 kHz betriebenen Adressen-Zähler 19 bzw. 20 bestimmten Adressen eine Folge von Binärzahlen, die für die zu untersuchenden Ausschnitte der Modulationssignale A und B charakteristisch ist.

Am Ende des Einlesevorgangs sind sämtliche Ausgänge der Adressen-Zähler 19 und 20 belegt. Über das NAND-Gatter 48 und die Leitung 47 gelangt ein Signal zum Eingang R des Kippglieds 41, das umkippt und über das Ausgangssignal am Ausgang Q an den Eingängen $\overline{W}$ der Speicher RAM A und RAM B den Befehl « Auslesen » gibt. Gleichzeitig wird über das Ausgangssignal am Ausgang $\overline{Q}$ der Taktgeber 11 umgeschaltet. Dieser liefert an seinem Ausgang 14 nunmehr eine hohe Frequenz von z. B. 1 MHz an die Adressen-Zähler 19 und 20. Die Speicherinhalte der Speicher RAM A und RAM B werden somit mit dieser Frequenz ausgelesen und durch das EXCLUSIV-ODER-Gatter 27 Wert für Wert miteinander verglichen. Sofern die beiden miteinander verglichenen Binärzahlen eines Wertepaars ungleich sind, erhöht das Gatter 27 den Inhalt des Fehler-Zählers 28 um eine Einheit.

Sofern die auf diese Weise bestimmte und im Fehler-Zähler 28 festgehaltene Fehlerrate unter einem vorgegebenen Wert von z. B. 128 Einheiten liegt, kann angenommen werden, daß die Modulationssignale A und B gleich sind. Die beiden zu prüfenden Sender strahlen das gleiche Programm aus. In diesem Fall wird das bistabile Kippglied 29 und das monostabile Kippglied 24 nicht umgekippt. Der nachtriggerbare Zeitschalter 33 erhält somit nach Ablauf seiner Einschaltzeit kein Eingangssignal. Er fällt in seinen Grundzustand zurück und liefert am Ausgang 38 ein Signal, das der Information « Modulation gleich » entspricht. Ein erneuter Sendersuchlauf oder dgl. wird dann nicht vorgenommen.

Übersteigt die Fehlerrate den vorgegebenen Wert, so kippt das bistabile Kippglied 29 um mit der Folge, daß das monostabile Kippglied 24 ebenfalls seinen Zustand ändert. Der nachtriggerbare Zeitschalter 33 erhält dann innerhalb seiner Einschaltzeit einen Impuls und behält seinen Einschaltzustand bei. Am Ausgang 38 liegt dann weiterhin ein der Information « Modulation ungleich » entsprechendes Signal vor. Der Zyklen-Zähler 32 wird um eine Einheit weitergezählt. Sofern sein Inhalt unter einem weiter unten näher angegebenen Wert liegt, läßt er den Zustand des bistabilen Kippglieds 35 unverändert.

Durch das Umkippen des monostabilen Kippglieds 24 für dessen Schaltzeit von z. B. 8 μsec wird die Verbindung vom Taktgeber 11 zum Adressen-Zähler 19 für diese Zeit gesperrt. Bei der angenommenen Taktfrequenz von 1 MHz bedeutet dies, daß der Speicher RAM A gegenüber dem Speicher RAM B um 8 Adressen verzögert angesteuert wird.

Vor Beginn des sich nunmehr anschließenden Vergleichs der gegeneinander in der beschriebenen Weise verzögerten Speicherinhalte der Speicher RAM A und RAM B wird der Fehler-Zähler 28 über das NAND-Gatter 54, die Leitung 53 und die damit verbundene Leitung 53' auf Null gesetzt und das bistabile Kippglied 29 wieder zurückgekippt. Der erneute Vergleich der beiden Speicherinhalte läuft nunmehr, wie für die nicht gegeneinander verschobenen Speicherinhalte beschrieben, ab. Sollte auch jetzt die mit dem Fehler-Zähler 28 bestimmte Fehlerrate höher als der vorgegebene Wert sein, so wird in der beschriebenen Weise der Speicherinhalt des Speichers RAM A erneut um 8 Adressen verzögert und wiederum mit dem Speicherinhalt des Speichers RAM B verglichen.

Diese Verschiebung des Speicherinhalts des Speichers RAM A um jeweils 8 Adressen wird solange fortgesetzt, bis bei an sich gleicher Modulation der beiden Sender durch die relative Verschiebung Laufzeitunterschiede der beiden Sendersignale ausgeglichen sind. Derartige Unterschiede haben ihre Ursache meist in unterschiedlichen Entfernungen des Empfängers von den beiden Sendestationen.

Sind die beiden untersuchten Programme jedoch ungleich, so wird die relative Verschiebung des Speicherinhalts von RAM A solange fortgesetzt, bis die gesamte relative Verschiebung der beiden Speicherinhalte von RAM A und RAM B der Zeitdauer eines Speicherinhalts entspricht. Dieser Fall liegt im angenommenen Beispiel nach 512 Verschiebungen des Speicherinhalts von RAM A um je 8 Adressen vor. Ist diese Zahl von Verschiebungen erfolgt, so liefert der Zyklen-Zähler 32 an seinem Ausgang 34 ein Signal. Das bistabile Kippglied 35 kippt um und erzeugt ein Signal am Ausgang 56, das der Information « Verschiebung beendet » entspricht. Gleichzeitig wird der Zyklen-Zähler 32 selbst über das ODER-Gatter 36 auf den Wert Null zurückgesetzt. Mit dem Ausgangssignal am Ausgang 56 kann nunmehr beispielsweise ein erneuter Sendersuchlauf gestartet werden und das Modulationssignal eines neuen Senders mit geänderter HF-Träger-Frequenz am Eingang 2 eingegeben und mit dem am Eingang 1 anliegenden Modulationssignal A des bereits untersuchten Senders verglichen werden. Zum Auslösen dieses Vergleichs ist wiederum ein Einspeicherbefehl am Eingang 39 erforderlich, der neben dem Umkippen des bistabilen Kippglieds 41 über eine Leitung 55 ein Rücksetzen des Zyklen-Zählers 32 und ein Umkippen des bistabilen Kippglieds 35 zur Folge hat.

Um zu vermeiden, daß bei Modulationssignalen gleich Null während der gesamten Einspeicherzeit der möglicherweise falsche Schluß « Modulation gleich » und damit « Programm gleich » gezogen wird, sorgen die beiden Schwellwertschalter 45 und 46 in Verbindung mit den UND-Gattern 42 und 40 in diesem Fall dafür, daß der Eingang S des bistabilen Kippglieds 41 blockiert wird. An die Eingänge $\overline{W}$ der Speicher RAM A und RAM B gelangt dann kein Einspeicherbefehl. Dies hat zur Folge, daß die Speicherinhalte der Speicher RAM A und RAM B nicht verändert und erneut miteinander verglichen werden. Das Ergebnis dieses Vergleichs ist wie das des vorangegangenen Vergleichs « Modulation ungleich ». In Verbindung mit einem zwischen den Dioden 43 und 44 und dem zugehörigen Schwellwertschalter 45 bzw. 46 angeordneten, nicht dargestellten Zeitschalter sorgen die Schwellwertschalter 45 und 46 auch dafür, daß während des Einlesens auftretende Modulationspausen ab einer Dauer nicht mehr eingelesen werden, die gleich der Schaltzeit der beiden Zeitschalter ist. Damit wird auch für größere Modulationspausen während des Einlesevorgangs die Gefahr eines falschen Ergebnisses des Modulationsvergleichs verringert.

**Ansprüche**

1. Verfahren zum Modulationsvergleich von zwei Rundfunksignalen, bei denen HF-Träger-Signalen unterschiedlicher Frequenz ein Modulationssignal überlagert ist, dadurch gekennzeichnet, daß von den beiden Modulationssignalen ein zeitgleicher Ausschnitt digitalisiert und in je einen Speicher (RAM A und RAM B) eingelesen wird, daß die Speicherinhalte für den Modulationsvergleich korreliert werden und daß bei nicht gegebener Übereinstimmung die Speicherinhalte gegeneinander verschoben und erneut miteinander korreliert werden, wobei die Verschiebung und die Korrelation der beiden Speicherinhalte bei fehlender Übereinstimmung solange fortgesetzt wird, bis die gesamte relative Verschiebung der Speicherinhalte der Zeitdauer eines Speicherinhaltes entspricht.

2. Verfahren nach Anspruch 1, dadurch gekennzeichnet, daß das Auslesen der digitalisierten Modulationssignale aus den Speichern (RAM A und RAM B) mit wesentlich größerer Geschwindigkeit als das Einlesen erfolgt.

3. Verfahren nach Anspruch 1 oder 2, dadurch gekennzeichnet, daß die als Primärwerte gegebenen Speicherinhalte Wert für Wert miteinander verglichen werden, die Zahl ungleicher Wertpaare gezählt und bei Überschreiten eines vorgegebenen Maximalwerts ein Verschiebesignal für einen Speicher (RAM A) ausgelöst wird.

4. Verfahren nach einem der Ansprüche 1 bis 3, dadurch gekennzeichnet, daß Modulationspausen innerhalb der Modulationssignale ab einer vorgegebenen Länge nicht mehr eingelesen werden.

5. Schaltanordnung zur Durchführung des Verfahrens nach einem der Ansprüche 1 bis 4, dadurch gekennzeichnet, daß die Speicher als Schreib/Lese-Speicher (RAM A und RAM B) ausgebildet und ihre Adresseingänge (15 bzw. 16) mit den Ausgängen (17 bzw. 18) je eines Adressen-Zählers (19 bzw. 20) verbunden sind, der an einem Taktgeber (11) angeschlossen ist.

6. Schaltanordnung nach Anspruch 5, dadurch gekennzeichnet, daß die Ausgänge der beiden Speicher über ein EXCLUSIV-ODER-Gatter (27) mit dem Eingang eines Fehler-Zählers (28) verbunden ist.

7. Schaltanordnung nach Anspruch 8, dadurch gekennzeichnet, daß der dem Maximalwert ungleicher Wertpaare entsprechende Ausgang des Fehler-Zählers (28) mit einem bistabilen Kippglied (29) verbunden ist, das über ein monostabiles Kippglied (24) eine Torschaltung (UND-Gatter 23) zwischen dem Taktgeber (11) und dem Eingang (21) eines Adressen-Zählers (19) kurzzeitig undurchlässig steuert.

8. Schaltanordnung nach Anspruch 7, dadurch gekennzeichnet, daß ein weiterer Ausgang (Q) des monostabilen Kippglieds (24) mit einem nachtriggerbaren Zeitschalter (33) verbunden ist, dessen Einschaltdauer etwas größer als ein Auslesezyklus der Speicher (RAM A und RAM B) ist.

**Claims**

1. Method of comparing the modulation of two radio signals wherein a modulation signal is superposed on HF carrier signals of different frequency, characterized in that a sector of equal duration is digitalized from the two modulation signals and is read into each of two stores (RAM A and RAM B), in that the store contents are correlated for the modulation comparison, and in that, if correspondence does not occur, the store contents are shifted relatively to each other and are again correlated to each other, the shift and the correlation of the two store contents being continued, in the absence of correspondence, until the entire relative shift of the store contents corresponds to the duration of one store content.

2. Method according to Claim 1, characterized in that read-out of the digitalized modulation signals from the stores (RAM A and RAM B) proceeds at a considerably greater speed than the read-in.

3. Method according to Claim 1 or Claim 2, characterized in that the store contents, given as primary values, are compared to each other word for word, the number of unlike pairs of values is counted and, when a prescribed maximum value is exceeded, a shift signal for a store (RAM A) is released.

4. Method according to any one of Claims 1 to 3, characterized in that modulation intervals within the modulation signals above a prescribed length are not read in.

5. Switching arrangement for performing the method according to any one of Claims 1 to 4, characterized in that the store is designed as a writing/reading store (RAM A and RAM B) and its address inputs (15 ; 16) are connected to the outputs (17 ; 18) of an address counter (19 ; 20) which is connected to a timer (11).

6. Switching arrangement according to Claim 5, characterized in that the outputs of the two stores are connected to the output of an error counter (28) by way of an EXCLUSIVE-OR gate (27).

7. Switching arrangement according to Claim 6, characterized in that the output of the error counter (28) that corresponds to the maximum value of unlike pairs of values is connected to a bistable oscillator (29) which, by way of a monostable oscillator (24), briefly blocks a gate circuit (AND gate 23) between the timer (11) and the input (21) of an address counter (19).

8. Switching arrangement according to Claim 7, characterized in that a further output (Q) of the monostable oscillator (24) is connected to a retriggerable time switch (33), the on-time of which is somewhat greater than a read-out cycle of the stores (RAM A and RAM B).

## Revendications

1. Procédé pour comparer les modulations de deux signaux de radiodiffusion aux signaux porteurs HF desquels est superposé un signal de modulation de fréquence différente, procédé caractérisé en ce qu'un extrait simultané des deux signaux de modulation est mis sous forme numérique et introduit respectivement dans une mémoire (RAM A et RAM B), les contenus des mémoires étant corrélés pour comparer les modulations et lorsqu'il n'y a pas coïncidence, les contenus des mémoires sont décalés l'un par rapport à l'autre et à nouveau corrélés, le décalage et la corrélation des deux contenus de mémoires en cas d'absence de coïncidence étant poursuivie jusqu'à ce que le décalage relatif total des contenus de mémoires corresponde à la durée d'un contenu de mémoire.

2. Procédé selon la revendication 1, caractérisé en ce que l'extraction des signaux de modulation mis sous forme numérique des mémoires (RAM A et RAM B) s'effectue à une vitesse notablement supérieure à celle de leur introduction.

3. Procédé selon revendication 1 ou 2, caractérisé en ce que les contenus des mémoires fournis comme valeurs primaires sont comparés entre eux valeur pour valeur, le nombre des paires de valeurs non identiques est compté et en cas de dépassement d'une valeur maximale prédéterminée, un signal de décalage est déclenché pour une mémoire (RAM A).

4. Procédé selon l'une des revendications 1 à 3, caractérisé en ce que les pauses de modulation dans les signaux de modulation ne sont plus introduites en mémoire à partir d'une longueur prédéterminée.

5. Dispositif de circuit pour la mise en œuvre du procédé selon l'une des revendications 1 à 4, caractérisé en ce que les mémoires revêtent la forme de mémoires d'enregistrement et de lecture (RAM A et RAM B) tandis que leurs entrées d'adresses (15 ou 16) sont respectivement reliées aux sorties (17 ou 18) d'un compteur d'adresses (19 ou bien 20) raccordé à un générateur de cadence (11).

6. Dispositif de circuit selon la revendication 5, caractérisé en ce que les sorties des deux mémoires sont reliées par l'intermédiaire d'une porte exclusive OU (27) à l'entrée d'un compteur d'erreurs (28).

7. Dispositif de circuit selon la revendication 6, caractérisé en ce que la sortie, correspondant à la valeur maximale de paires de valeurs non identiques, du compteur d'erreurs (28) est reliée à un organe basculant bistable (29) qui, par l'intermédiaire d'un organe basculant monostable (24) commande à l'état non passant pendant un court instant, un circuit de portes (porte ET 23) entre (11) et l'entrée (21) d'un compteur d'adresses (19).

8. Dispositif de circuit selon la revendication 7, caractérisé en ce qu'une autre sortie (Q) de l'organe basculant monostable (24) est reliée à un commutateur temporisé susceptible d'être déclenché ultérieurement (33) dont la durée d'enclenchement est un peu supérieure à un cycle de lecture des mémoires (RAM A et RAM B).